(19) Europäisches Patentamt
European Patent Office
Office européen des brevets

(11) **EP 3 276 834 B1**

(12) **FASCICULE DE BREVET EUROPEEN**

(45) Date de publication et mention
de la délivrance du brevet:
**20.05.2020 Bulletin 2020/21**

(51) Int Cl.:
***H03M 3/00*** *(2006.01)*

(21) Numéro de dépôt: **17182719.9**

(22) Date de dépôt: **24.07.2017**

(54) **MODULATEUR SIGMA-DELTA À ÉTAGES DE MISE EN FORME DE BRUIT MULTIPLES**

SIGMA-DELTA-MODULATOR MIT MEHRFACHSTUFEN FÜR DIE RAUSCHFORMUNG

SIGMA-DELTA MODULATOR WITH MULTIPLE NOISE-SHAPING STAGES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.07.2016 FR 1657232**

(43) Date de publication de la demande:
**31.01.2018 Bulletin 2018/05**

(73) Titulaire: **Commissariat à l'Energie Atomique et aux Energies**
**Alternatives**
**75015 Paris (FR)**

(72) Inventeurs:
• **VERDANT, Arnaud**
**38330 SAINT-NAZAIRE-LES-EYMES (FR)**
• **BOUTAYEB, Mohammed Saad**
**20000 CASABLANCA (MA)**

(74) Mandataire: **Cabinet Beaumont**
**4, Place Robert Schuman**
**B.P. 1529**
**38025 Grenoble Cedex 1 (FR)**

(56) Documents cités:
**US-A- 5 870 048**

• **HO C C ET AL: "Gain mismatch effect of cascaded sigma delta modulator reduced by serial technique", PROCEEDINGS OF THE 1999 IEEE INTERNATIONAL SYMPOSIUM ON CIRCUITS AND SYSTEMS / ISCAS '99, MAY 30 - JUNE 2, 1999, ORLANDO, FLORIDA, IEEE SERVICE CENTER, PISCATAWAY, NJ, vol. 2, 30 mai 1999 (1999-05-30), pages 9-12, XP010341519, DOI: 10.1109/ISCAS.1999.780473 ISBN: 978-0-7803-5471-5**
• **RAMIN ZANBAGHI ET AL: "A 75-dB SNDR, 5-MHz Bandwidth Stage-Shared 2 2 MASH $\Delta \Sigma$ Modulator Dissipating 16 mW Power", IEEE TRANSACTIONS ON CIRCUITS AND SYSTEMS I: REGULAR PAPERS, IEEE, US, vol. 59, no. 8, août 2012 (2012-08), pages 1614-1625, XP011454341, ISSN: 1549-8328, DOI: 10.1109/TCSI.2012.2206509**
• **MAGHARI N ET AL: "Sturdy MASH [Delta]-Sigma modulator", ELECTRONICS LET, IEE STEVENAGE, GB, vol. 42, no. 22, 26 octobre 2006 (2006-10-26), pages 1269-1270, XP006027654, ISSN: 0013-5194, DOI: 10.1049/EL:20062718**
• **NIMA MAGHARI ET AL: "74 dB SNDR Multi-Loop Sturdy-MASH Delta-Sigma Modulator Using 35 dB Open-Loop Opamp Gain", IEEE JOURNAL OF SOLID-STATE CIRCUITS, IEEE SERVICE CENTER, PISCATAWAY, NJ, USA, vol. 44, no. 8, août 2009 (2009-08), pages 2212-2221, XP011264509, ISSN: 0018-9200, DOI: 10.1109/JSSC.2009.2022302**
• **BENABES P ET AL: "New high-order universal Sigma[Delta] modulator", ELECTRONICS LET, IEE STEVENAGE, GB, vol. 31, no. 1, 5 janvier 1995 (1995-01-05), pages 8-9, XP006002299, ISSN: 0013-5194, DOI: 10.1049/EL:19950040**

**Description**

Domaine

La présente demande concerne le domaine des convertisseurs analogique-numérique, et, plus particulièrement, des convertisseurs sigma-delta.

Exposé de l'art antérieur

Un convertisseur sigma-delta comprend classiquement un modulateur sigma-delta et un filtre numérique. Le signal analogique à numériser est appliqué en entrée du modulateur, et est échantillonné par ce dernier à une fréquence relativement élevée (par rapport à la fréquence maximale du signal d'entrée), appelée fréquence de sur-échantillonnage. Le modulateur produit, à la fréquence de sur-échantillonnage, des échantillons binaires représentatifs du signal analogique d'entrée. Le train de bits de sortie du modulateur sigma-delta est traité par le filtre numérique qui en extrait une valeur numérique sur N-bits (N étant la résolution de quantification du convertisseur sigma-delta), représentative du signal d'entrée. Le nombre d'échantillons binaires, c'est-à-dire le nombre de périodes de sur-échantillonnage, nécessaires pour produire une valeur numérique de sortie sur N-bits est désigné par l'acronyme OSR, de l'anglais "Over Sampling Ratio" (taux de sur-échantillonnage).

Le rôle du modulateur sigma-delta est de mettre en forme d'une part le signal utile par l'intermédiaire de sa fonction de transfert de signal STF, et d'autre part le bruit de quantification par l'intermédiaire de sa fonction de transfert de bruit NTF. La STF est la fonction de transfert liant le signal analogique d'entrée à numériser au signal de sortie du modulateur, et la NTF est la fonction de transfert liant le bruit de quantification introduit par le modulateur au signal de sortie du modulateur. La NTF permet de repousser le bruit de quantification en dehors de la bande d'intérêt (dans laquelle se trouve le signal). Le modulateur sigma-delta constitue donc un étage de mise en forme du bruit de quantification. Le filtre numérique est conçu de manière à extraire le signal dans les bandes de fréquence où l'atténuation du bruit de quantification par la NTF est élevée (c'est-à-dire là où se trouve le signal). La fonction de transfert de signal STF est généralement égale à 1, et la fonction de transfert de bruit NTF s'exprime par exemple, pour un modulateur d'ordre p, par $NTF(z)=(1-z^{-1})^p$.

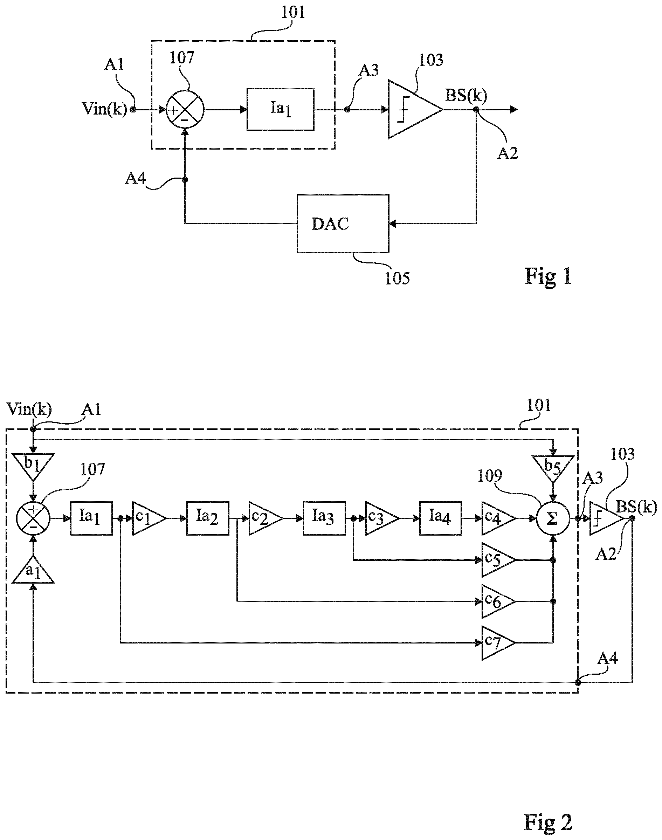

La figure 1 est un schéma électrique simplifié illustrant, sous forme de blocs, un exemple d'un modulateur sigma-delta d'ordre 1.

Le modulateur de la figure 1 comprend une borne d'entrée A1 destinée à recevoir le signal analogique d'entrée Vin à numériser, et une borne de sortie A2 destinée à fournir une suite d'échantillons binaires BS représentative du signal Vin. Le modulateur de la figure 1 comporte un circuit analogique d'intégration 101, un convertisseur analogique-numérique 1-bit 103 et une boucle de rétroaction comportant un convertisseur numérique-analogique 1-bit 105. Le circuit analogique d'intégration 101 comprend une première borne d'entrée connectée à la borne A1 d'application du signal Vin, et une borne de sortie A3 connectée à l'entrée du circuit de conversion analogique-numérique 1-bit 103, par exemple un comparateur. La sortie du convertisseur analogique-numérique 1-bit 103 est connectée à la sortie A2 du modulateur, et est en outre reliée, par l'intermédiaire de la boucle de rétroaction, à une deuxième borne d'entrée A4 du circuit analogique d'intégration 101. Dans cet exemple, le circuit analogique d'intégration 101 comprend un soustracteur 107 dont l'entrée positive est reliée à la borne A1 d'application du signal Vin et dont l'entrée négative est reliée à la borne A4 de sortie de la boucle de rétroaction, et un intégrateur analogique $Ia_1$ dont l'entrée est connectée à la sortie du soustracteur 107 et dont la sortie est connectée à la borne A3 d'entrée du convertisseur analogique-numérique 1-bit 103.

A chaque cycle k de durée $T_{OSR}$ d'une phase de conversion du signal analogique d'entrée Vin en une valeur numérique de sortie, où $T_{OSR}$ désigne la période de sur-échantillonnage du convertisseur, k est un entier allant de 1 à OSR, et OSR est le nombre de cycles successifs de la phase de conversion, le circuit d'intégration 101 prélève un échantillon analogique Vin(k) du signal d'entrée, et le modulateur fournit, en sortie du convertisseur analogique-numérique 1-bit 103, un échantillon binaire BS(k) du signal de sortie. Plus particulièrement, dans l'exemple représenté, à chaque cycle k, l'intégrateur $Ia_1$ du circuit 101 reçoit sur son entrée un signal égal à la différence entre le signal d'entrée Vin(k) et le signal de rétroaction BS(k-1) (converti dans le domaine analogique par le convertisseur numérique-analogique 1-bit 105). La valeur de sortie $Ia_1(k)$ de l'intégrateur $Ia_1$ est mise à jour en conséquence, c'est-à-dire incrémentée de la valeur Vin(k)-BS(k-1), puis quantifiée par le convertisseur analogique-numérique 103 pour produire l'échantillon de sortie BS(k).

A titre de variante, le circuit d'intégration analogique 101 peut comprendre plusieurs intégrateurs analogiques cascadés. Il peut aussi comprendre un ou plusieurs soustracteurs, un ou plusieurs sommateurs, et/ou un ou plusieurs coefficients de pondération. Le nombre p d'intégrateurs analogiques définit généralement l'ordre du modulateur sigma-delta. Plus l'ordre p du modulateur est élevé, plus le nombre OSR d'échantillons nécessaires à l'obtention d'une valeur numérique de sortie sur N-bits peut être réduit (à niveaux de bruit de quantification identiques). En contrepartie, les modulateurs sigma-delta sont d'autant plus complexes à réaliser que leur ordre est élevé (stabilisation délicate).

Le filtre numérique (non représenté) d'un convertisseur sigma-delta comprend classiquement, selon la structure du modulateur, un ou plusieurs intégrateurs numériques (généralement au moins autant que d'intégrateurs analogiques dans le modulateur), par exemple des compteurs, et réalise une fonction de filtrage destinée à extraire l'information utile du train de bits produit par le modulateur sigma-delta.

On s'intéresse ici plus particulièrement à la réalisation de modulateurs sigma-delta d'ordre supérieur à 1.

Le document US5870048 concerne la domaine des convertisseurs sigma-delta du type MASH et cherche à mutualiser des composants des différents étages pour limiter le nombre total de composants du convertisseur.

Résumé

Ainsi, un mode de réalisation prévoit un modulateur sigma-delta comprenant au moins des premier et deuxième sous-modulateurs comportant chacun un circuit analogique d'intégration, le circuit analogique d'intégration du premier sous-modulateur ayant un noeud de sortie connecté à un noeud d'entrée du circuit analogique d'intégration du deuxième sous-modulateur, le modulateur comprenant en outre une capacité de couplage ayant une première électrode connectée à un noeud de sortie du circuit analogique d'intégration du deuxième sous-modulateur, et un comparateur dont l'entrée est reliée à la première électrode de la capacité de couplage par un premier interrupteur de commutation et à une deuxième électrode de la capacité de couplage par un deuxième interrupteur de commutation.

Selon un mode de réalisation, le modulateur est adapté à mettre en œuvre une phase de conversion d'un signal analogique d'entrée en un train de bits de sortie, la phase de conversion comportant une pluralité de cycles de fonctionnement, dans lequel, à chaque cycle de la phase de conversion, pendant une première partie du cycle, les premier et deuxième interrupteurs sont respectivement ouvert et fermé, et une valeur binaire Y1 est lue en sortie du comparateur, et, pendant une deuxième partie du cycle, les premier et deuxième interrupteurs sont respectivement fermé et ouvert, et une valeur binaire Y2 est lue en sortie du comparateur, les valeurs Y1 et Y2 étant ensuite combinées en une valeur de sortie Y du modulateur définissant le train de bits de sortie et le premier signal de rétroaction du modulateur.

Selon un mode de réalisation, à chaque cycle de la phase de conversion, le circuit analogique d'intégration du deuxième sous-modulateur intègre un signal représentatif de la différence entre la valeur binaire Y1 et un signal de sortie du circuit analogique d'intégration du premier sous-modulateur.

Selon un mode de réalisation, à chaque cycle de la phase de conversion, un signal de rétroaction représentatif de la valeur binaire Y2 est soustrait au signal intégré par le circuit analogique d'intégration du deuxième sous-modulateur.

Selon un mode de réalisation, à chaque cycle de la phase de conversion, le circuit analogique d'intégration du premier sous-modulateur intègre un signal représentatif du signal analogique d'entrée.

Selon un mode de réalisation, à chaque cycle de la phase de conversion, un signal de rétroaction représentatif de la valeur binaire de sortie du modulateur est soustrait au signal intégré par le circuit analogique d'intégration du premier sous-modulateur.

Selon un mode de réalisation, le circuit analogique d'intégration du premier sous-modulateur comprend au moins deux intégrateurs analogiques cascadés, et au moins un circuit de sommation pondérée des valeurs de sortie desdits intégrateurs, la sortie du circuit de sommation constituant la sortie dudit circuit analogique d'intégration.

Selon un mode de réalisation, le circuit analogique d'intégration du deuxième sous-modulateur comprend un unique intégrateur analogique dont l'entrée et la sortie sont connectées respectivement à l'entrée et à la sortie dudit circuit analogique d'intégration.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

> la figure 1, précédemment décrite, représente de façon schématique un exemple d'un modulateur sigma-delta d'ordre 1 ;
> la figure 2 représente de façon schématique un exemple d'un modulateur sigma-delta d'ordre 4 ;
> la figure 3 représente de façon schématique, sous forme de blocs fonctionnels, un exemple d'un modulateur sigma-delta à étages de mise en forme de bruit multiples ;
> la figure 4 est un schéma électrique détaillé d'un exemple d'implémentation du modulateur sigma-delta de la figure 3 ; et
> la figure 5 est un schéma électrique détaillé illustrant un exemple d'un mode de réalisation d'un modulateur sigma-delta à étages de mise en forme de bruit multiples.

Description détaillée

De mêmes éléments ont été désignés par de mêmes références aux différentes figures. Par souci de clarté, seuls les éléments qui sont utiles à la compréhension des modes de réalisation décrits ont été représentés et sont détaillés. En particulier, les détails de réalisation des filtres numériques des convertisseurs sigma-delta décrits n'ont pas été représentés, la réalisation de ces filtres étant à la portée de l'homme du métier à la lecture de la présente description. Dans la présente description, on utilise le terme "connecté" pour désigner une liaison électrique directe, sans composant électronique intermédiaire, par exemple au moyen d'une ou plusieurs pistes conductrices ou fils conducteurs, et le terme "couplé" ou le terme "relié", pour désigner une liaison électrique qui peut être directe (signifiant alors "connecté") ou indirecte (c'est-à-dire via un ou plusieurs composants intermédiaires).

La figure 2 illustre de façon schématique, sous forme de blocs, un exemple d'un modulateur sigma-delta d'ordre 4.

Le modulateur sigma-delta de la figure 2 diffère du modulateur sigma-delta de la figure 1 essentiellement par l'architecture de son circuit analogique d'intégration 101. Dans l'exemple de la figure 2, le circuit analogique d'intégration 101 comporte un soustracteur 107, quatre intégrateurs analogiques cascadés $Ia_1$, $Ia_2$, $Ia_3$ et $Ia_4$, et un circuit de sommation 109 ($\Sigma$). Chaque intégrateur analogique comporte une entrée et une sortie, et a par exemple une fonction de transfert en $z^{-1}/(1-z^{-1})$, c'est-à-dire que, à chaque cycle, le signal intégré, ou signal de sortie de l'intégrateur, est incrémenté de la valeur du signal appliqué en entrée de l'intégrateur. Dans cet exemple, le soustracteur 107 reçoit sur son entrée positive le signal d'entrée Vin(k) pondéré par un coefficient $b_1$, et sur son entrée négative le signal de rétroaction BS(k-1) pondéré par un coefficient $a_1$. L'intégrateur $Ia_1$ reçoit sur son entrée le signal de sortie du soustracteur 107, c'est-à-dire un signal égal à la différence b1*Vin(k)-a1*BS(k-1). L'intégrateur $Ia_2$ reçoit sur son entrée un signal égal au signal de sortie de l'intégrateur $Ia_1$ pondéré par un coefficient $c_1$. L'intégrateur $Ia_3$ reçoit sur son entrée un signal égal au signal de sortie de l'intégrateur $Ia_2$ pondéré par un coefficient $c_2$. L'intégrateur $Ia_4$ reçoit sur son entrée un signal égal au signal de sortie de l'intégrateur $Ia_3$ pondéré par un coefficient $c_3$. Le circuit de sommation 109 additionne le signal d'entrée Vin(k) pondéré par un coefficient $b_5$, et les signaux de sortie des intégrateurs $Ia_1$, $Ia_2$, $Ia_3$ et $Ia_4$, pondérés respectivement par des coefficients $c_7$, $c_6$, $c_5$ et $c_4$. La sortie du circuit de sommation 109 est connectée à la borne A3 de sortie du circuit 101.

Dans cet exemple, on considère que le signal d'entrée Vin et le signal de sortie BS du modulateur sont normalisés, c'est-à-dire que la valeur 0 du signal binaire BS correspond à un niveau de tension égal à la plus petite valeur que peut prendre le signal analogique Vin, et que la valeur 1 du signal BS correspond à un niveau de tension égal à la plus grande valeur que peut prendre le signal Vin. Ainsi, la boucle de rétroaction du modulateur est une simple piste conductrice reliant la borne A2 à la borne A4, et le signal de rétroaction est directement le signal BS. Dans le cas où le signal binaire de sortie BS n'est pas à la même échelle que le signal d'entrée Vin, la boucle de rétroaction peut comporter, comme dans l'exemple de la figure 1, un convertisseur numérique-analogique 1-bit dont l'entrée est reliée à la borne A2 et dont la sortie est reliée à la borne A4, le signal de rétroaction étant alors le signal de sortie du convertisseur numérique-analogique 1-bit.

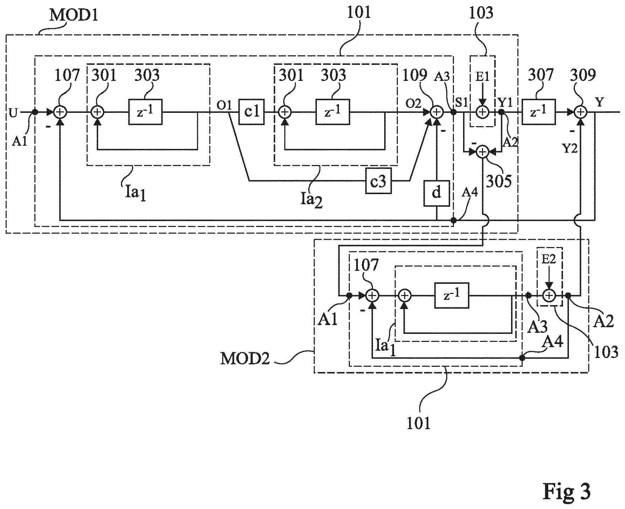

De nombreuses variantes d'architectures du circuit analogique d'intégration 101 peuvent être envisagées. De façon générale, le circuit analogique d'intégration 101 d'un modulateur sigma-delta d'ordre p supérieur ou égal à 1 peut comporter p intégrateurs analogiques $Ia_j$, avec j entier allant de 1 à p, chaque intégrateur analogique $Ia_j$ recevant sur son entrée un signal égal à la différence entre le signal d'entrée Vin(k) pondéré par un coefficient $b_j$ et le signal de rétroaction BS(k-1) pondéré par un coefficient $a_j$, à laquelle s'additionne, si le rang j de l'intégrateur $Ia_j$ est supérieur à 1, le signal de sortie de l'intégrateur $Ia_{j-1}$ de rang précédant pondéré par un coefficient $c_{j-1}$. Le circuit de sommation $\Sigma$ additionne le signal d'entrée Vin(k) pondéré par un coefficient $b_{p+1}$, le signal de sortie de l'intégrateur $Ia_p$ de rang p pondéré par un coefficient $c_p$, et, si p est supérieur à 1, le ou les signaux de sortie des intégrateurs de rang p-l, avec l'entier allant de 1 à p-1, pondérés respectivement par des coefficients $c_{p+1}$. Certains des coefficients susmentionnés peuvent être nuls. Par exemple, dans le modulateur d'ordre 4 de la figure 2, les coefficients $b_2$, $b_3$, $b_4$, $a_2$, $a_3$ et $a_4$ sont nuls, et, dans le modulateur d'ordre 1 de la figure 1, les coefficients b1, a1 et c1 sont unitaires, et le coefficient b2 est nul. En outre, dans le sous-modulateur d'ordre 2 MOD1 de la figure 3 (qui sera décrit ci-après), les coefficients b1, a1 et c2 sont unitaires, et les coefficients a2, b2 et b3 sont nuls, et, dans le sous-modulateur d'ordre 1 MOD1 de la figure 3 (qui sera décrit ci-après), les coefficients b1, a1 et c1 sont unitaires et le coefficient b2 est nul.

Dans certaines architectures d'ordre p supérieur ou égal à 1, le circuit de sommation $\Sigma$ peut en outre recevoir en entrée le signal de rétroaction BS(k-1) pondéré par un coefficient de pondération spécifique.

Par ailleurs, le circuit d'intégration analogique 101 d'un modulateur sigma-delta d'ordre p supérieur à 1 peut en outre comporter une ou plusieurs contre-réactions analogiques de la sortie d'un intégrateur analogique vers l'entrée d'un intégrateur analogique amont, au travers d'un coefficient de pondération spécifique.

De plus, dans une architecture d'ordre p supérieur à 1, la sortie d'un intégrateur de rang i peut être additionnée, au travers d'un coefficient de pondération spécifique, à l'entrée d'un intégrateur aval de rang supérieur ou égal à i+2.

En outre, des délais peuvent être introduits entre les différents étages du circuit 101, et/ou entre le circuit 101 et le convertisseur 103.

Une limitation des architectures susmentionnées à étage de mise en forme de bruit unique, c'est-à-dire comportant une boucle de rétroaction unique de la sortie de l'étage de quantification 103 vers l'entrée du circuit analogique d'intégration 101, est que la réalisation d'un modulateur d'ordre élevé est en pratique complexe à mettre en œuvre. En particulier, un problème qui se pose est que le modulateur peut avoir un comportement instable pour certains niveaux du signal d'entrée.

Pour pallier cet inconvénient, on a proposé des modulateurs sigma-delta de type MASH (de l'anglais "Multi Stage Noise Shaping" - modulateur à étages de mise en forme du bruit multiples), c'est-à-dire des modulateurs d'ordre p supérieur à 1 constitués par la mise en série de plusieurs sous-modulateurs sigma-delta d'ordre inférieur à p, chaque sous-modulateur pouvant avoir une architecture traditionnelle à étage de mise en forme de bruit unique du type décrit ci-dessus, c'est-à-dire comportant un circuit analogique d'intégration, un convertisseur analogique-numérique 1-bit, et une boucle de rétroaction pouvant comporter un convertisseur numérique-analogique. Le principe de fonctionnement des modulateurs sigma-delta de type MASH et de type SMASH est par exemple décrit dans l'article "Sturdy MASH Δ-Σ modulator" de Maghari et al. (ELECTRONICS LETTERS 26th October 2006 Vol.42 No.22). A titre d'exemple, un modulateur sigma-delta d'ordre 2 de type MASH comprend un premier sous-modulateur d'ordre 1, ou sous-modulateur amont, par exemple du type décrit en relation avec la figure 1, recevant le signal analogique à numériser sur son entrée analogique, et un deuxième sous-modulateur d'ordre 1, ou sous-modulateur aval, par exemple du type décrit en relation avec la figure 1, recevant sur son entrée analogique un signal représentatif de l'erreur de quantification du sous-modulateur amont. Lors d'une phase de conversion du signal analogique d'entrée en une valeur numérique, chacun des sous-modulateurs d'ordre 1 fournit un train de OSR bits en sortie de son convertisseur analogique-numérique 1-bit, les deux trains de bits étant recombinés en un seul train de OSR bits par un circuit logique de recombinaison. Le train de bits recombiné est intégré numériquement par un circuit de filtrage numérique générant une valeur numérique de sortie du convertisseur sigma-delta. Plus généralement, les topologies MASH se déclinent quels que soient les ordres des sous-modulateurs reliés en série, et quel que soit le nombre de sous-modulateurs reliés en série. Les sous-modulateurs sont reliés de façon que chaque sous-modulateur de l'association en série de sous-modulateurs, à l'exception du premier sous-modulateur, reçoive un signal d'entrée représentatif de l'erreur de quantification du sous-modulateur précédent. Un avantage des modulateurs sigma-delta de type MASH est qu'ils permettent d'obtenir des ordres de modulation élevés, en s'affranchissant des problèmes usuellement rencontrés (notamment des problèmes d'instabilité) dans la réalisation de modulateurs sigma-delta traditionnels (à étage de mise en forme de bruit unique).

La figure 3 représente de façon schématique, sous forme de blocs fonctionnels, un exemple d'un modulateur sigma-delta de type SMASH.

Dans cet exemple, le modulateur est de type SMASH 2-1, c'est-à-dire qu'il comporte un premier sous-modulateur sigma-delta d'ordre 2 MOD1, ou sous-modulateur amont, suivi d'un deuxième sous-modulateur sigma-delta d'ordre 1 MOD2, ou sous-modulateur aval.

Le sous-modulateur MOD1 présente une topologie d'ordre 2 traditionnelle à étage de mise en forme de bruit unique. On y retrouve, comme dans les exemples décrits ci-dessus, un circuit analogique d'intégration 101 dont une première entrée A1 est destinée à recevoir un signal analogique d'entrée U à convertir, un convertisseur analogique-numérique 1-bit 103 dont l'entrée est reliée à une sortie A3 du circuit analogique d'intégration 101, et une boucle de rétroaction reliant la sortie A2 du convertisseur analogique-numérique 103 à une deuxième entrée A4 du circuit analogique d'intégration 101. Dans cet exemple, le circuit analogique d'intégration 101 comprend un soustracteur 107, deux intégrateurs analogiques $Ia_1$ et $Ia_2$, et un sommateur 109. L'entrée positive du soustracteur 107 est reliée à l'entrée A1 du circuit 101, et l'entrée négative du soustracteur 107 est reliée à l'entrée A4 du circuit 101. La sortie du soustracteur 107 est reliée à l'entrée de l'intégrateur analogique $Ia_1$, et la sortie de l'intégrateur analogique $Ia_1$ est reliée à l'entrée de l'intégrateur analogique $Ia_2$ par l'intermédiaire d'un coefficient de pondération c1. Le sommateur 109 additionne le signal de sortie O1 de l'intégrateur $Ia_1$ pondéré par un coefficient c3 au signal de sortie O2 de l'intégrateur $Ia_2$, et soustrait à cette somme le signal de rétroaction Y appliqué sur l'entrée A4 du circuit 101, pondéré par un coefficient d. La sortie du sommateur 109 constitue la sortie (borne A3) du circuit analogique d'intégration 101 du sous-modulateur MOD1, et est reliée à l'entrée du convertisseur analogique-numérique 103 du sous-modulateur MOD1. Dans l'exemple de la figure 3, le convertisseur analogique numérique 1-bit 103 du sous-modulateur MOD1 est représenté sous la forme d'un sommateur ajoutant au signal de sortie S1 (borne A3) du circuit analogique d'intégration 101 du sous-modulateur MOD1 un bruit de quantification E1 introduit par le convertisseur 103. Dans cet exemple, chaque intégrateur analogique $Ia_i$ comprend un sommateur 301, et un opérateur de retard 303 à gain unitaire noté $Z^{-1}$. Une première entrée du sommateur 301 est reliée à l'entrée de l'intégrateur analogique, la sortie du sommateur 301 étant reliée à l'entrée de l'opérateur 303, et la sortie de l'opérateur 303 étant reliée d'une part à la sortie de l'intégrateur analogique et d'autre part à une deuxième entrée du sommateur 301 par une boucle de rétroaction positive à gain unitaire. A chaque cycle k de fonctionnement du convertisseur sigma-delta, le sommateur 301 additionne le signal reçu au cycle k à l'entrée de l'intégrateur $Ia_i$ et un signal interne à l'intégrateur $Ia_i$ correspondant au signal de sortie de l'opérateur 301, c'est-à-dire à la valeur de sortie de l'intégrateur $Ia_i$ au cycle précédent.

Le sous-modulateur MOD2 présente une topologie d'ordre 1 traditionnelle du type décrit en relation avec la figure 1. On y retrouve un circuit analogique d'intégration 101 comprenant une première entrée A1 recevant un signal analogique égal à la différence entre le signal Y1 de sortie du convertisseur analogique-numérique 103 du sous-modulateur MOD1 et le signal S1 de sortie du circuit analogique d'intégration 101 du sous-modulateur MOD1, c'est-à-dire égal à l'erreur de quantification E1 introduite par le convertisseur analogique-numérique 103 du sous-modulateur MOD1. Pour cela, le modulateur sigma-delta de la figure 3 comprend, entre les sous-modulateurs MOD1 et MOD2, un soustracteur 305 dont l'entrée positive est reliée à la sortie A2 du sous-modulateur MOD1, dont l'entrée négative est reliée à la sortie A3 du circuit analogique d'intégration 101 du sous-modulateur MOD1, et dont la sortie est reliée à l'entrée A1 du circuit analogique d'intégration 101 du sous-modulateur MOD2. Le sous-modulateur MOD2 comprend en outre un convertisseur analogique-numérique 1-bit 103 dont l'entrée est connectée à une borne de sortie A3 de son circuit analogique d'intégration 101, et une boucle de rétroaction reliant la sortie A2 de son convertisseur analogique-numérique 103 à une deuxième entrée A4 de son circuit analogique d'intégration 101. Dans cet exemple, le circuit analogique d'intégration 101 du sous-modulateur MOD2 comprend un soustracteur 107 et un intégrateur analogique $Ia_1$. L'entrée positive du soustracteur 107 est reliée à l'entrée A1 du circuit 101, et l'entrée négative du soustracteur 107 est reliée à l'entrée A4 du circuit 101. La sortie du soustracteur 107 est reliée à l'entrée de l'intégrateur analogique $Ia_1$. La sortie de l'intégrateur analogique Ia1 constitue la sortie A3 du circuit analogique d'intégration 101, et est reliée à l'entrée du convertisseur analogique-numérique 103. L'intégrateur analogique $Ia_1$ du sous-modulateur MOD2 est par exemple identique ou similaire à l'intégrateur $Ia_1$ du sous-modulateur MOD1. Dans l'exemple de la figure 3, le convertisseur analogique numérique 1-bit 103 du sous-modulateur MOD2 est représenté sous la forme d'un sommateur ajoutant au signal de sortie (borne A3) du circuit analogique d'intégration 101 du sous-modulateur MOD2 un bruit de quantification E2.

Dans l'exemple de la figure 3, le modulateur sigma-delta comprend en outre un opérateur de retard à gain unitaire 307, noté $z^{-1}$, et un soustracteur 309. L'entrée de l'opérateur 307 est reliée à la sortie A2 du sous-modulateur MOD1. L'entrée positive du soustracteur 309 est reliée à la sortie de l'opérateur 307. L'entrée négative du soustracteur 309 est reliée à la sortie A2 du sous-modulateur MOD2. Dans cet exemple, la sortie du soustracteur 309 constitue la sortie du modulateur sigma-delta. Le circuit formé par l'opérateur à retard 307 et le soustracteur 309 recombine les trains de bits Y1 de sortie du sous-modulateur MOD1 et Y2 de sortie du sous-modulateur MOD2 en un train de bits Y de sortie du modulateur sigma-delta, appliqué en entrée du filtre numérique (non représenté) du convertisseur sigma-delta.

Dans l'exemple représenté, la boucle de rétroaction du sous-modulateur MOD2 est une boucle de rétroaction directe, c'est-à-dire reliant directement (ou le cas échéant par l'intermédiaire d'un convertisseur numérique-analogique 1-bit) la sortie A2 du sous-modulateur MOD2 à l'entrée A4 du circuit analogique d'intégration 101 du sous-modulateur MOD2. La boucle de rétroaction du sous-modulateur MOD1 est par contre une boucle de rétroaction indirecte, comprenant le circuit de recombinaison formé par les éléments 307 et 309. En d'autres termes, la boucle de rétroaction du sous-modulateur MOD1 ne relie pas directement la sortie A2 du sous-modulateur MOD1 à l'entrée A4 du circuit analogique d'intégration 101 du sous-modulateur MOD1, mais relie la sortie du modulateur sigma-delta (c'est-à-dire la sortie du soustracteur 309 fournissant le signal Y) à l'entrée A4 du circuit analogique d'intégration 101 du sous-modulateur MOD1 (le cas échéant, par l'intermédiaire d'un convertisseur numérique-analogique non représenté).

Les équations suivantes décrivent la réponse du modulateur sigma-delta de la figure 3 :

$$Y2 = z^{-1}E1 + (1 - z^{-1})E2$$

$$Y1 = E1 - dY + c3\frac{z^{-1}}{1 - z^{-1}}(U - Y) + c1\frac{z^{-1}}{(1 - z^{-1})^2}(U - Y)$$

$$Y = z^{-1}Y1 - Y2$$

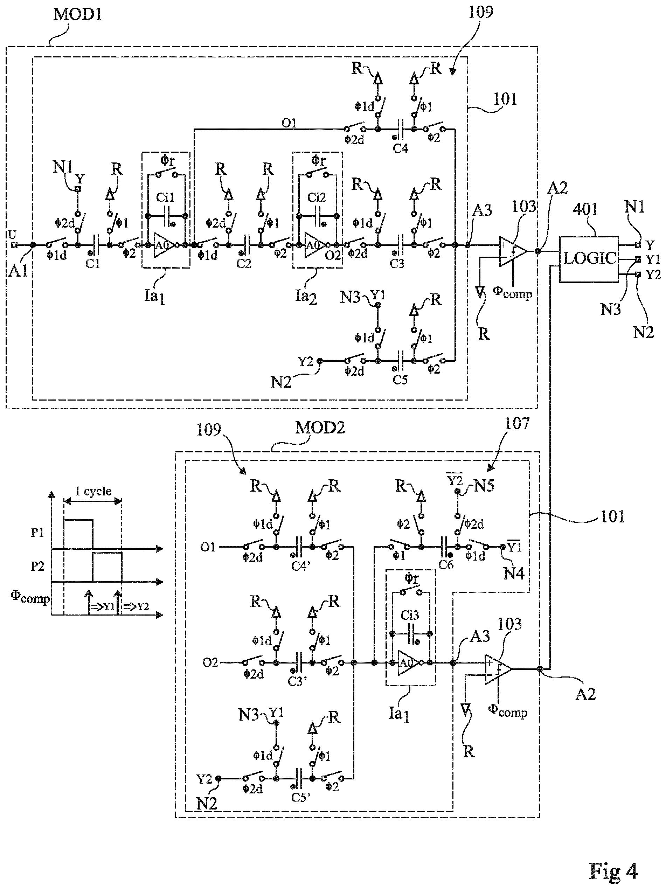

La figure 4 est un schéma électrique détaillé illustrant un exemple d'implémentation du modulateur sigma-delta de la figure 3.

Dans l'exemple de la figure 4, chacun des intégrateurs $Ia_1$, respectivement $Ia_2$ du sous-modulateur MOD1 comprend un amplificateur opérationnel AO dont l'entrée est reliée à la sortie par une capacité d'intégration Ci1, respectivement Ci2. L'entrée et la sortie de l'amplificateur opérationnel forment respectivement l'entrée et la sortie de l'intégrateur. De façon similaire, l'intégrateur $Ia_1$ du sous-modulateur MOD2 comprend un amplificateur opérationnel AO dont l'entrée est reliée à la sortie par une capacité d'intégration Ci3. Chaque intégrateur comprend en outre, en parallèle de sa capacité d'intégration, un interrupteur de réinitialisation commandé par un signal Φr. Dans la présente description, par souci de simplification, les interrupteurs du modulateur sont désignés par les mêmes références que leurs signaux de commande respectifs. Ainsi, bien que les interrupteurs commutant les différentes capacités du modulateur soient différents, de mêmes appellations sont utilisées pour les interrupteurs commandés simultanément.

Dans cet exemple, chacun des sous-modulateurs MOD1 et MOD2 comprend un circuit analogique d'intégration 101 et un convertisseur analogique-numérique 1-bit 103 formé par un comparateur dont l'entrée est connectée à une borne de sortie A3 du circuit analogique d'intégration 101 du sous-modulateur, et dont la sortie est connectée à une borne de sortie A2 du sous-modulateur. En fonctionnement, un signal interne de chaque comparateur passe d'un état haut à un état bas selon que le signal d'entrée du comparateur est supérieur ou inférieur à un seuil, par exemple égal à un potentiel de référence appliqué sur un noeud de référence R du circuit. Le signal interne du comparateur est recopié sur sa borne de sortie A2 à chaque front montant ou descendant d'un signal de commande $\Phi$comp.

Dans le sous-modulateur MOD1, l'implémentation du circuit analogique d'intégration 101 est la suivante. La sortie de l'intégrateur $Ia_1$ est reliée à une première électrode d'une capacité C2 par un premier interrupteur $\Phi$1d, et la sortie de l'intégrateur $Ia_2$ est reliée à une première électrode d'une capacité C3 par un premier interrupteur $\Phi$2d. La deuxième électrode de la capacité C2 est reliée à l'entrée de l'intégrateur $Ia_2$ par un premier interrupteur $\Phi$2, et la deuxième électrode de la capacité C3 est reliée à la borne de sortie A3 du circuit 101 par un deuxième interrupteur $\Phi$2. Les première et deuxième électrodes de la capacité C2 sont en outre reliées à un noeud R d'application d'un potentiel de référence, respectivement par l'intermédiaire d'un deuxième interrupteur $\Phi$2d et par l'intermédiaire d'un premier interrupteur $\Phi$1. De plus, les première et deuxième électrodes de la capacité C3 sont reliées au noeud R respectivement par l'intermédiaire d'un deuxième interrupteur $\Phi$1d et par l'intermédiaire d'un deuxième interrupteur $\Phi$1. Le circuit analogique d'intégration 101 du sous-modulateur MOD1 comprend en outre une capacité C1 dont une première électrode est reliée à la borne d'entrée A1 du sous-modulateur par un troisième interrupteur $\Phi$1d et dont la deuxième électrode est reliée à l'entrée de l'intégrateur $Ia_1$ par un troisième interrupteur $\Phi$2. Les première et deuxième électrodes de la capacité C1 sont en outre reliées respectivement à un noeud N1 recevant le signal de sortie Y du modulateur par un troisième interrupteur $\Phi$2d et au noeud R par un troisième interrupteur $\Phi$1. Le circuit analogique d'intégration 101 du sous-modulateur MOD1 comprend en outre une capacité C4 dont une première électrode est reliée à la sortie de l'intégrateur $Ia_1$ par un quatrième interrupteur $\Phi$2d et dont la deuxième électrode est reliée à la borne de sortie A3 du circuit 101 par un quatrième interrupteur $\Phi$2. Les première et deuxième électrodes de la capacité C4 sont en outre reliées au noeud R respectivement par un quatrième interrupteur $\Phi$1d et par un quatrième interrupteur $\Phi$1. Le circuit analogique d'intégration 101 du sous-modulateur MOD1 comprend de plus une capacité C5 dont une première électrode est reliée à un noeud N2 recevant le signal Y2 de sortie du sous-modulateur MOD2 par l'intermédiaire d'un cinquième interrupteur $\Phi$2d et dont la deuxième électrode est reliée à la borne de sortie A3 du circuit 101 par un cinquième interrupteur $\Phi$2. Les première et deuxième électrodes de la capacité C5 sont en outre reliées respectivement à un noeud N3 recevant le signal de sortie Y1 du sous-modulateur MOD1 par l'intermédiaire d'un cinquième interrupteur $\Phi$1d et au noeud R par l'intermédiaire d'un cinquième interrupteur $\Phi$1.

Le circuit formé par les capacités C4, C3 et C5 et par les interrupteurs de commutation $\Phi$2d, $\Phi$1d, $\Phi$1, $\Phi$2 associés à ces capacités est dupliqué en entrée de l'intégrateur analogique $Ia_1$ du sous-modulateur MOD2. Autrement dit, outre son intégrateur analogique $Ia_1$, le circuit analogique d'intégration 101 du sous-modulateur MOD2 comprend :

une capacité C3' sensiblement identique à la capacité C3 (aux dispersions de fabrication près) dont une première électrode est reliée à la sortie de l'intégrateur $Ia_2$ du sous-modulateur MOD1 par un sixième interrupteur $\Phi$2d et dont la deuxième électrode est reliée à l'entrée de l'intégrateur $Ia_1$ du sous-modulateur MOD2 par un sixième interrupteur $\Phi$2, les première et deuxième électrodes de la capacité C3' étant en outre reliées au noeud R respectivement par un sixième interrupteur $\Phi$1d et par un sixième interrupteur $\Phi$1 ;
une capacité C4' sensiblement identique à la capacité C4 (aux dispersions de fabrication près) dont une première électrode est reliée à la sortie de l'intégrateur $Ia_1$ du sous-modulateur MOD1 par un septième interrupteur $\Phi$2d et dont la deuxième électrode est reliée à l'entrée de l'intégrateur $Ia_1$ du sous-modulateur MOD2 par un septième interrupteur $\Phi$2, les première et deuxième électrodes de la capacité C4' étant en outre reliées au noeud R respectivement par un septième interrupteur $\Phi$1d et par un septième interrupteur $\Phi$1 ; et
une capacité C5' sensiblement identique à la capacité C5 (aux dispersions de fabrication près) dont une première électrode est reliée au noeud N2 par un huitième interrupteur $\Phi$2d et dont la deuxième électrode est reliée à l'entrée de l'intégrateur $Ia_1$ du sous-modulateur MOD2 par un huitième interrupteur $\Phi$2, les première et deuxième électrodes de la capacité C5' étant en outre reliées respectivement au noeud N3 par un huitième interrupteur $\Phi$1d et au noeud R par un huitième interrupteur $\Phi$1.

Le circuit analogique d'intégration 101 du sous-modulateur MOD2 comprend en outre une capacité C6 dont une première électrode est reliée à un noeud N4 recevant un signal $\overline{Y1}$ complémentaire du signal Y1 de sortie du sous-modulateur MOD1 par l'intermédiaire d'un neuvième interrupteur $\Phi$1d (le noeud N4 est par exemple relié au noeud N3 par un inverseur) et dont la deuxième électrode est reliée à l'entrée de l'intégrateur $Ia_1$ du sous-modulateur MOD2 par un neuvième interrupteur Φ1. Les première et deuxième électrodes de la capacité C6 sont en outre reliées respectivement à un noeud N5 recevant un signal $\overline{Y2}$ complémentaire du signal Y2 de sortie du sous-modulateur MOD2 par l'intermédiaire d'un neuvième interrupteur Φ2d (le noeud N5 est par exemple relié au noeud N2 par un inverseur) et au noeud R par un neuvième interrupteur Φ2.

Dans cet exemple, la sortie de l'intégrateur $Ia_1$ du sous-modulateur MOD2 est connectée à la borne de sortie A3 du circuit analogique d'intégration 101 du sous-modulateur MOD2.

Le modulateur sigma-delta de la figure 4 comprend en outre un circuit logique 401 (LOGIC) comprenant deux entrées binaires reliées respectivement à la borne de sortie A2 du convertisseur analogique-numérique 1-bit 103 du sous-modulateur MOD1 et à la borne de sortie A2 du convertisseur analogique numérique 1-bit 103 du sous modulateur MOD2, et trois sorties binaires reliées respectivement aux nœuds N1, N2 et N3 et fournissant le signal binaire de sortie Y1 du sous-modulateur MOD1, le signal binaire de sortie Y2 du sous-modulateur MOD2, et le signal binaire de sortie Y du modulateur.

Un chronogramme est représenté sur la figure 4 pour montrer l'enchainement par cycle de deux phases successives P1 et P2 de commutation des interrupteurs du modulateur. Lors de la phase P1, les interrupteurs Φ2 et Φ2d sont fermés (rendus passants), les interrupteurs Φ1 et Φ1d étant maintenus ouverts (bloqués) . A la fin de la phase P1, les interrupteurs Φ2 et Φ2d sont ouverts. Lors de la phase P2, les interrupteurs Φ1 et Φ1d sont fermés (rendus passants), les interrupteurs Φ2 et Φ2d étant maintenus ouverts (bloqués). A la fin de la phase P2, les interrupteurs Φ1 et Φ1d sont ouverts. A la fin de chacune des phases P1 et P2, les signaux internes des comparateurs 103 des sous-modulateurs MOD1 et MOD2 sont échantillonnés (fronts montants du signal Φcomp) pour générer les signaux Y1 et Y2.

Dans l'implémentation de la figure 4, la fonction du circuit sommateur 109 de la figure 3 est mise en œuvre d'une part par les capacités C4, C3 et C5 et les interrupteurs de commutation connectés à ces capacités, et d'autre part par les capacités C4', C3' et C5' et les interrupteurs de commutation connectés à ces capacités.

A chaque cycle k d'une phase de conversion du signal analogique d'entrée U en une valeur numérique, pendant la phase P1, un signal S1 résultant de la sommation pondérée des signaux O1 de sortie de l'intégrateur $Ia_1$, O2 de sortie de l'intégrateur $Ia_2$, et Y de sortie du modulateur sigma-delta, est généré sur le noeud A3 d'entrée du convertisseur analogique-numérique 103 du sous-modulateur MOD1, avec S1=-(O2+c3*O1-d*Y), les coefficients c3 et d étant fixés respectivement par le ratio des capacités C3 et C4 et par le ratio des capacités C5 et C3. On notera que dans cet exemple, le signal Y(k)=Y1(k-1)-Y2(k) n'est pas directement appliqué en entrée du circuit de sommation, mais est regénéré par ce dernier dans la capacité C5, à partir des signaux Y1 et Y2. A la fin de la phase P1, le signal S1 est quantifié par le comparateur 103 du sous-modulateur MOD1 pour générer le signal Y1. En parallèle, pendant la phase P1, le signal S1 est en outre généré sur le noeud d'entrée de l'intégrateur $Ia_1$ du sous-modulateur MOD2 par le circuit de sommation dupliqué comportant les capacités C4', C3' et C5' et les interrupteurs de commutation connectés à ces capacités. La valeur du signal S1 s'ajoute donc à la valeur de sortie de l'intégrateur $Ia_1$ du sous-modulateur MOD2.

Pendant la phase P2 suivant la phase P1, le signal $\overline{Y1}$ est appliqué en entrée de l'intégrateur $Ia_1$ du sous-modulateur MOD2. Ainsi, à la fin du cycle, la valeur de sortie de l'intégrateur $Ia_1$ du sous-modulateur MOD2 a bien été incrémentée d'une valeur correspondant au bruit de quantification E1 du convertisseur analogique-numérique 103 du sous-modulateur MOD1 (auquel est soustrait le signal de rétroaction Y2 du sous-modulateur MOD2 du fait du préchargement de la capacité C6 au potentiel $-\overline{Y2}$ durant la phase P1).

Dans l'exemple de la figure 4, la fonction du circuit soustracteur 107 du sous-modulateur MOD1 de la figure 3 est mise en œuvre par la capacité C1 et les interrupteurs de commutation associés à cette capacité, et la fonction du circuit soustracteur 107 du sous-modulateur MOD2 de la figure 3 est mise en œuvre par la capacité C6 et les interrupteurs de commutation associés à cette capacité.

Un inconvénient de l'architecture de la figure 4 réside dans le coût en matériel lié à la duplication, à l'entrée du sous-modulateur MOD2, des capacités du circuit de sommation utilisé dans le sous-modulateur MOD1 pour générer le signal S1 de sortie du circuit analogique d'intégration 101 du sous-modulateur MOD1. Un autre inconvénient est lié à l'appariement, inévitablement imparfait, des capacités dupliquées, qui a pour effet d'introduire une composante additionnelle du bruit de quantification E1 dans l'expression du signal de sortie Y du modulateur.

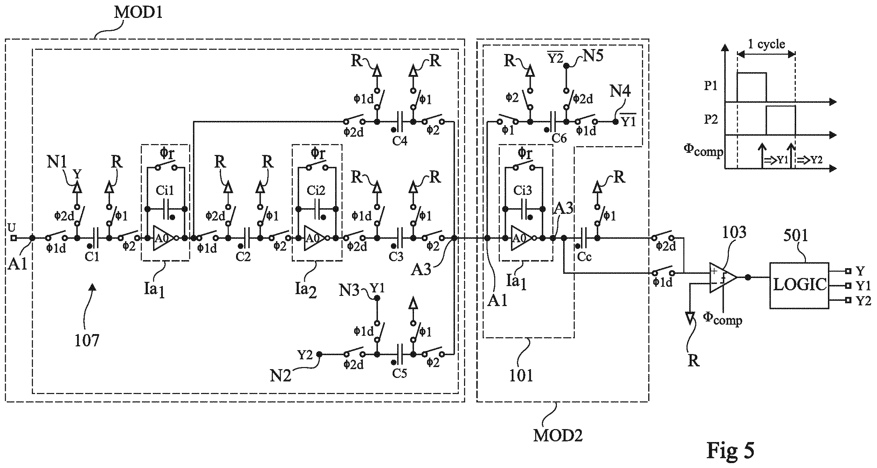

La figure 5 est un schéma électrique détaillé illustrant un exemple d'un mode de réalisation d'un modulateur sigma-delta à étages de mise en forme de bruit multiples.

Fonctionnellement, le modulateur sigma-delta de la figure 5 est un modulateur de type SMASH 2-1 identique ou similaire au modulateur de la figure 3.

Structurellement, le modulateur sigma-delta de la figure 5 comprend des éléments communs avec le modulateur sigma-delta de la figure 4. Seules les différences entre les deux implémentations seront détaillées ci-après.

Le circuit analogique d'intégration 101 du sous-modulateur MOD1 du modulateur de la figure 5 est identique ou similaire au circuit analogique d'intégration 101 du sous-modulateur MOD1 décrit en relation avec la figure 4.

Le circuit analogique d'intégration 101 du sous-modulateur MOD2 de la figure 5 diffère du circuit analogique d'intégration 101 du sous-modulateur MOD2 de la figure 4 essentiellement en ce qu'il ne comprend pas de réplication du circuit de sommation de sortie du circuit analogique d'intégration 101 du sous-modulateur MOD1. Autrement dit, le circuit analogique d'intégration 101 du sous-modulateur MOD2 de la figure 5 diffère du circuit analogique d'intégration 101 du sous-modulateur MOD2 de la figure 4 essentiellement en ce qu'il ne comprend pas les capacités C4', C3' et C5' et les interrupteurs de commutation associés à ces capacités.

Dans l'exemple de la figure 5, les circuits analogiques d'intégration 101 des sous-modulateurs MOD1 et MOD2 sont directement reliés en série, c'est-à-dire que la borne de sortie A3 du circuit analogique d'intégration 101 du sous-modulateur MOD1 est connectée à la borne d'entrée A1 du circuit analogique d'intégration 101 du sous-modulateur MOD2 (correspondant au noeud d'entrée de l'intégrateur $Ia_1$ du sous-modulateur MOD2).

Dans le mode de réalisation de la figure 5, le modulateur sigma-delta comprend un unique convertisseur analogique-numérique 1-bit 103, par exemple un comparateur identique ou similaire aux comparateurs 103 des sous-modulateurs MOD1 et MOD2 de la figure 4, partagé par les sous-modulateurs MOD1 et MOD2. L'entrée du convertisseur 103 est reliée à la sortie du circuit analogique d'intégration 101 du sous-modulateur MOD2. Plus particulièrement, dans l'exemple représenté, le modulateur sigma-delta comprend une capacité Cc ayant une première électrode connectée au noeud A3 de sortie du circuit analogique d'intégration 101 du sous-modulateur MOD2 (correspondant au noeud de sortie de l'intégrateur $Ia_1$ du sous-modulateur MOD2), et dont la deuxième électrode est reliée à l'entrée du convertisseur analogique-numérique 103 par un interrupteur $\Phi 2d$. La première électrode de la capacité Cc est en outre reliée à l'entrée du convertisseur 103 par un interrupteur $\Phi 1d$. De plus, la deuxième électrode de la capacité Cc est reliée au noeud R par un interrupteur $\Phi 1$.

Le modulateur sigma-delta de la figure 5 comprend en outre un circuit logique 501 (LOGIC) comprenant une entrée binaire reliée à la borne de sortie du convertisseur analogique-numérique 1-bit 103, et trois sorties binaires reliées respectivement aux noeuds N1, N2 et N3 et fournissant le signal binaire de sortie Y1 du sous-modulateur MOD1, le signal binaire de sortie Y2 du sous-modulateur MOD2, et le signal binaire de sortie Y du modulateur.

Un chronogramme est représenté sur la figure 5 pour montrer l'enchainement par cycle de deux phases successives P1 et P2 de commutation des interrupteurs du modulateur. Comme dans l'exemple de la figure 4, lors de la phase P1, les interrupteurs $\Phi 2$ et $\Phi 2d$ sont fermés, les interrupteurs $\Phi 1$ et $\Phi 1d$ étant maintenus ouverts (bloqués). A la fin de la phase P1, les interrupteurs $\Phi 2$ et $\Phi 2d$ sont ouverts. Lors de la phase P2, les interrupteurs $\Phi 1$ et $\Phi 1d$ sont fermés (rendus passants), les interrupteurs $\Phi 2$ et $\Phi 2d$ étant maintenus ouverts (bloqués). A la fin de la phase P2, les interrupteurs $\Phi 1$ et $\Phi 1d$ sont ouverts. A la fin de chacune des phases P1 et P2, le signal interne du comparateur 103 est échantillonné (fronts montants du signal $\Phi comp$) pour générer les signaux Y1 et Y2.

Dans l'implémentation de la figure 5, la fonction du circuit sommateur 109 de la figure 3 est mise en œuvre par les capacités C4, C3 et C5 et les interrupteurs de commutation connectés à ces capacités. A chaque cycle k d'une phase de conversion du signal analogique d'entrée U en une valeur numérique, pendant la phase P1, un signal S1 résultant de la sommation pondérée des signaux O1 de sortie de l'intégrateur $Ia_1$ du sous-modulateur MOD1, O2 de sortie de l'intégrateur $Ia_2$ du sous-modulateur MOD1, et Y de sortie du modulateur sigma-delta, est généré sur le noeud de sortie A3 du circuit analogique d'intégration 101 du sous-modulateur MOD1, avec S1=-(O2+c3*O1-d*Y). Ce signal S1 est appliqué sur le noeud d'entrée A1 du circuit analogique d'intégration 101 du sous-modulateur aval MOD2, c'est-à-dire, dans l'exemple représenté, à l'entrée de l'intégrateur $Ia_1$ du sous-modulateur MOD2. Le signal S1 est donc intégré par l'intégrateur $Ia_1$ du sous-modulateur MOD2, c'est-à-dire que, pendant la phase P1, la valeur de l'intégrateur $Ia_1$ est incrémentée de la valeur S1. Au préalable, lors de la phase P2 du cycle précédent lors de laquelle les interrupteurs $\Phi 1$ sont passants, la capacité Cc est chargée à la valeur de sortie de l'intégrateur Ia1. Ainsi, pendant la phase P1 suivante ($\Phi 1$ bloqué), la capacité de couplage de sortie Cc introduit en entrée du comparateur 103 un décalage en tension par rapport à la valeur de sortie courante de l'intégrateur Ia1 égal à la valeur de sortie de l'intégrateur $Ia_1$ à la fin du cycle précédent. Autrement dit, pendant la phase P1, la variation de tension observée en entrée du comparateur 103 du fait de la capacité de couplage Cc correspond à la grandeur S1. A la fin de la phase P1, la valeur S1 observée sur la deuxième électrode de la capacité Cc est quantifiée par le comparateur 103 pour générer le signal Y1.

Pendant la phase P2 suivant la phase P1, le signal $\overline{Y1}$ est appliqué en entrée de l'intégrateur $Ia_1$ du sous-modulateur MOD2 (noeud N4). Ainsi, pendant la phase P2, la valeur de sortie de l'intégrateur $Ia_1$ du sous-modulateur MOD2 est incrémentée d'une valeur correspondant au bruit de quantification E1 introduit par le convertisseur analogique-numérique 103 lors de la quantification du signal S1, auquel est soustrait la contre-réaction Y2 (noeud N5). A la fin de la phase P2, le signal de sortie de l'intégrateur $Ia_1$ du sous-modulateur MOD2 est directement quantifié par le comparateur 103 (sans passer par la capacité de couplage Cc) pour obtenir le signal Y2.

Ainsi, fonctionnellement, le circuit de la figure 5 se comporte sensiblement de la même manière que le circuit de la figure 3. Toutefois, dans l'implémentation de la figure 5, plutôt que de dupliquer le circuit de génération du signal S1 à l'entrée du sous-modulateur MOD2 comme cela est fait dans l'implémentation de la figure 4, on prévoit de reconstruire le signal S1 par dérivation du signal de sortie de l'intégrateur $Ia_1$ du modulateur aval MOD2, au travers de la capacité de couplage Cc.

Un avantage de l'implémentation de la figure 5 réside dans le fait que le signal S1 n'est pas dupliqué, ce qui, outre l'avantage en coût matériel lié à la suppression des capacités C4', C3', C5' et de leurs interrupteurs de commutation, permet, lors de la génération du signal d'erreur de quantification E1=Y1-S1, d'éviter les risques de défaut d'intégrité du signal S1 liés à un défaut d'appariement des capacités dupliquées.

Un autre avantage de l'implémentation de la figure 5 est qu'elle permet d'économiser un convertisseur analogique-numérique 1-bit par rapport à l'implémentation de la figure 4.

Des modes de réalisation particuliers ont été décrits. Diverses variantes et modifications apparaîtront à l'homme de l'art. En particulier, les modes de réalisation décrits ne se limitent pas à l'exemple d'architecture de modulateur sigma-delta de type SMASH 2-1 décrite en relation avec les figures 3 et 5. Plus généralement, la solution proposée, mettant en œuvre un circuit analogique de dérivation du signal de sortie d'un circuit analogique d'intégration 101 d'un sous-modulateur aval pour reconstruire un signal de sortie d'un circuit analogique d'intégration 101 d'un sous-modulateur amont, peut être utilisée dans tout type de modulateur sigma-delta comportant au moins deux sous-modulateurs en cascade.

## Revendications

1. Modulateur sigma-delta comprenant au moins des premier (101-MOD1) et deuxième (101-MOD2) circuits analogique d'intégration comprenant chacun au moins un intégrateur analogique ($Ia_1$, $Ia_2$), chaque intégrateur analogique ($Ia_1$, $Ia_2$) comprenant un amplificateur opérationnel (AO) dont l'entrée est reliée à la sortie par une capacité d'intégration (Ci1, Ci2, Ci3), le premier circuit analogique d'intégration (101-MOD1) ayant un noeud de sortie (A3) connecté à un noeud d'entrée (A1) du deuxième circuit analogique d'intégration (101-MOD2), le modulateur comprenant en outre une capacité de couplage (Cc) distincte desdites capacités d'intégration (Ci1, Ci2, Ci3), la capacité de couplage (Cc) ayant une première électrode connectée à un noeud de sortie (A3) du deuxième circuit analogique d'intégration (101-MOD2), et un comparateur (103) dont l'entrée est reliée à la première électrode de la capacité de couplage (Cc) par un premier interrupteur de commutation (Φ1d) et à une deuxième électrode de la capacité de couplage (Cc) par un deuxième interrupteur de commutation (Φ2d),
le modulateur étant adapté à mettre en œuvre une phase de conversion d'un signal analogique d'entrée (U) en un train de bits de sortie (Y), la phase de conversion comportant une pluralité de cycles de fonctionnement divisés chacun en des première (P1) et deuxième (P2) phases successives, dans lequel, à chaque cycle (k) de la phase de conversion :

   pendant la première phase (P1) du cycle :

   - le premier circuit analogique d'intégration (101-MOD1) intègre un signal représentatif de la différence entre le signal analogique d'entrée (U) et un premier signal de rétroaction (Y), et fournit un signal de sortie S1 sur son noeud de sortie (A3) ;
   - le deuxième circuit analogique d'intégration (101-MOD2) intègre uniquement le signal S1 ;
   - les premier (Φ1d) et deuxième (Φ2d) interrupteurs sont respectivement ouvert et fermé, de sorte que le seul signal S1 est transmis sur l'entrée du comparateur (103) par l'intermédiaire de la capacité de couplage (Cc) ; et
   - une valeur binaire Y1 correspondant au signal S1 quantifié sur 1-bit est lue en sortie du comparateur (103),

   et, pendant la deuxième phase (P2) du cycle :

   - le deuxième circuit analogique d'intégration (101-MOD2) intègre un signal représentatif de la différence entre un deuxième signal de rétroaction (Y2) et la valeur binaire Y1 ;

   les premier (Φ1d) et deuxième (Φ2d) interrupteurs sont respectivement fermé et ouvert, de sorte que le signal de sortie du deuxième circuit analogique d'intégration (101-MOD2) est appliqué sur l'entrée du comparateur (103) ; et
   une valeur binaire Y2 correspondant au signal de sortie du deuxième circuit analogique d'intégration (101-MOD2) quantifiée sur 1-bit est lue en sortie du comparateur (103), les valeurs Y1 et Y2 étant ensuite combinées en une valeur de sortie (Y) du modulateur définissant le train de bits de sortie et le premier signal de rétroaction du modulateur.

2. Modulateur selon la revendication 1, dans lequel la deuxième électrode de la capacité de couplage (Cc) est en outre reliée à un noeud d'application d'un potentiel de référence (R) par un troisième interrupteur (Φ1), le troisième interrupteur (Φ1) étant ouvert pendant la première phase (P1) de chaque cycle (k) de la phase de conversion et fermé pendant la deuxième phase (P2) de chaque cycle (k) de la phase de conversion.

3. Modulateur selon la revendication 1 ou 2, dans lequel le premier circuit analogique d'intégration (101) comprend au moins deux intégrateurs analogiques (Ia$_1$, Ia$_2$) cascadés, et au moins un circuit (109) de sommation pondérée des valeurs de sortie (O1, O2) desdits intégrateurs, la sortie du circuit de sommation (109) constituant la sortie dudit circuit analogique d'intégration (101).

4. Modulateur selon l'une quelconque des revendications 1 à 3, dans lequel le circuit analogique d'intégration (101) du deuxième sous-modulateur (MOD2) comprend un unique intégrateur analogique (Ia1) dont l'entrée et la sortie sont connectées respectivement à l'entrée et à la sortie dudit circuit analogique d'intégration (101).

**Patentansprüche**

1. Ein Sigma-Delta-Modulator mit mindestens einer ersten (101-MOD1) und einer zweiten (101-MOD2) analogen Integrationsschaltung, die jeweils mindestens einen analogen Integrator (Ia$_1$, Ia$_2$) aufweisen, wobei jeder analoge Integrator (Ia$_1$, Ia$_2$) mit einem Operationsverstärker (AO), dessen Eingang mit seinem Ausgang durch einen Integrationskondensator (Ci1, Ci2, Ci3) gekoppelt ist, wobei die erste analoge Integrationsschaltung (101-MOD1) einen Ausgangsknoten (A3) aufweist, der mit einem Eingangsknoten (A1) der zweiten analogen Integrationsschaltung (101-MOD2) verbunden ist, wobei der Modulator ferner einen Koppelkondensator (Cc) umfasst, der sich von den Integrationskondensatoren (Ci1, Ci2, Ci3) unterscheidet, wobei der Koppelkondensator (Cc) eine erste Elektrode aufweist, die mit einem Ausgangsknoten (A3) der zweiten analogen Integrationsschaltung (101-MOD2) verbunden ist, und einen Komparator (103), dessen Eingang über einen ersten Schalter (Φ1d) mit der ersten Elektrode des Koppelkondensators (Cc) und über einen zweiten Schalter (Φ2d) mit einer zweiten Elektrode des Koppelkondensators (Cc) gekoppelt ist,
   wobei der Modulator in der Lage ist, eine Phase der Umwandlung eines analogen Eingangssignals (U) in eine Ausgangsbitfolge (Y) zu implementieren, wobei die Umwandlungsphase eine Vielzahl von Betriebszyklen umfasst, die jeweils in eine erste (P1) und eine zweite (P2) aufeinanderfolgende Phase unterteilt sind, wobei für jeden Zyklus (k) der Umwandlungsphase gilt:

   während der ersten Phase (P1) des Zyklus:

   - die erste analoge Integrationsschaltung (101-MOD1) ein Signal integriert, das für die Differenz zwischen dem analogen Eingangssignal (U) und einem ersten Rückkopplungssignal (Y) repräsentativ ist, und ein Ausgangssignal S1 an ihrem Ausgangsknoten (A3) liefert;
   - die zweite analoge Integrationsschaltung (101-MOD2) integriert nur das Signal S1;
   - der erste (Φ1d) und der zweite (Φ2d) Schalter jeweils aus- und eingeschaltet sind, so dass nur das Signal S1 über den Koppelkondensator (Cc) an den Eingang des Komparators (103) übertragen wird; und
   - ein binärer Wert Y1, der dem 1-Bit-quantisierten Signal S1 entspricht, aus dem Ausgang des Komparators (103) gelesen wird,

   und während der zweiten Phase (P2) des Zyklus:

   - die zweite analoge Integrationsschaltung (101-MOD2) integriert ein Signal, das die Differenz zwischen einem zweiten Rückkopplungssignal (Y2) und dem Binärwert Y1 darstellt;

   der erste (Φ1d) und der zweite (Φ2d) Schalter jeweils ein- und ausgeschaltet werden, so dass das Ausgangssignal der zweiten analogen Integrationsschaltung (101-MOD2) an den Eingang des Komparators (103) angelegt wird; und
   ein binärer Wert Y2, der dem 1-Bit-quantisierten Ausgangssignal der zweiten analogen Integrationsschaltung (101-MOD2) entspricht, wird vom Ausgang des Komparators (103) gelesen, wobei die Werte Y1 und Y2 dann zu einem Ausgangsbit des Modulators kombiniert werden.

2. Modulator nach Anspruch 1, wobei die zweite Elektrode des Koppelkondensators (Cc) über einen dritten Schalter (Φ1) weiter an einen Knotenpunkt zum Anlegen eines Referenzpotentials (R) gekoppelt ist, wobei der dritte Schalter (Φ1) während der ersten Phase (P1) jedes Zyklus (k) der Umwandlungsphase aus- und während der zweiten Phase (P2) jedes Zyklus (k) der Umwandlungsphase eingeschaltet ist.

**3.** Modulator nach Anspruch 1 oder 2, wobei die erste analoge Integrationsschaltung (101) mindestens zwei kaskadierte analoge Integratoren (Ia$_1$, Ia$_2$) und mindestens eine Schaltung (109) aufweist, die eine gewichtete Summe der Ausgangswerte (O1, O2) der Integratoren erreicht, wobei der Ausgang der Summierschaltung (109) den Ausgang der analogen Integrationsschaltung (101) bildet.

**4.** Modulator nach einem der Ansprüche 1 bis 3, wobei die analoge Integrationsschaltung (101) des zweiten Submodulators (MOD2) einen einzelnen analogen Integrator (Ia$_1$) aufweist, dessen Eingang und Ausgang mit dem Eingang bzw. dem Ausgang der analogen Integrationsschaltung (101) verbunden ist.

**Claims**

**1.** A sigma-delta modulator comprising at least first (101-MOD1) and second (101-MOD2) analog integration circuits each comprising at least one analog integrator (Ia$_1$, Ia$_2$), each analog integrator (Ia$_1$, Ia$_2$) comprising an operational amplifier (AO) having its input coupled to its output by an integration capacitor (Ci1, Ci2, Ci3), the first analog integration circuit (101-MOD1) having an output node (A3) connected to an input node (A1) of the second analog integration circuit (101-MOD2), the modulator further comprising a coupling capacitor (Cc) different from said integration capacitors (Ci1, Ci2, Ci3), the coupling capacitor (Cc) having a first electrode connected to an output node (A3) of the second analog integration circuit (101-MOD2), and a comparator (103) having its input coupled to the first electrode of the coupling capacitor (Cc) by a first switch (Φ1d) and to a second electrode of the coupling capacitor (Cc) by a second switch (Φ2d),
the modulator being capable of implementing a phase of conversion of an analog input signal (U) into an output bit train (Y), the conversion phase comprising a plurality of operating cycles, each divided into first (P1) and second (P2) successive phases, wherein, for each cycle (k) of the conversion phase:

during the first phase (P1) of the cycle:

- the first analog integration circuit (101-MOD1) integrates a signal representative of the difference between the analog input signal (U) and a first feedback signal (Y), and supplies an output signal S1 on its output node (A3);
- the second analog integration circuit (101-MOD2) only integrates signal S1;
- the first (Φ1d) and second (Φ2d) switches are respectively turned off and on, so that only signal S1 is transmitted to the input of the comparator (103) via the coupling capacitor (Cc); and
- a binary value Y1 corresponding to 1-bit quantized signal S1 is read from the output of the comparator (103),

and, during the second phase (P2) of the cycle:

- the second analog integration circuit (101-MOD2) integrates a signal representative of the difference between a second feedback signal (Y2) and binary value Y1;

the first (Φ1d) and second (Φ2d) switches are respectively turned on and off, so that the output signal of the second analog integration circuit (101-MOD2) is applied to the input of the comparator (103); and
a binary value Y2 corresponding to the 1-bit quantized output signal of the second analog integration circuit (101-MOD2) is read from the output of the comparator (103), values Y1 and Y2 being then combined into one output bit of the modulator.

**2.** The modulator of claim 1, wherein the second electrode of the coupling capacitor (Cc) is further coupled to a node of application of a reference potential (R) by a third switch (Φ1), the third switch (Φ1) being off during the first phase (P1) of each cycle (k) of the conversion phase and on during the second phase (P2) of each cycle (k) of the conversion phase.

**3.** The modulator of claim 1 or 2, wherein the first analog integration circuit (101) comprises at least two cascaded analog integrators (Ia$_1$, Ia$_2$), and at least one circuit (109) achieving a weighted sum of the output values (O1, O2) of said integrators, the output of the summing circuit (109) forming the output of said analog integration circuit (101).

**4.** The modulator of any of claims 1 to 3, wherein the analog integration circuit (101) of the second sub-modulator (MOD2) comprises a single analog integrator (Ia$_1$) having its input and its output respectively connected to the input and to the output of said analog integration circuit (101).

Fig 1

Fig 2

Fig 3

Fig 4

Fig 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• US 5870048 A

**Littérature non-brevet citée dans la description**

• **MAGHARI et al.** Sturdy MASH $\Delta$-$\sum$ modulator. *ELEC-TRONICS LETTERS,* 26 Octobre 2006, vol. 42 (22